# FASCICULE DE BREVET EUROPEEN

(11) **EP 1 661 850 B1**
(45) Date de publication et mention de la délivrance du brevet: **13.06.2007**
(21) Numéro de dépôt: 05292510.4
(22) Date de dépôt: 25.11.2005
(51) Int. Cl.: B81B 7/00, H01L 23/053

(54) **Procédé de conditionnement de micro-composants utilisant une matrice**
Verfahren zur Häusung von Mikrobauteilen mittels einer Pressform
Method for packaging a micro-component using a mould

(30) Priorité: 26.11.2004 FR 0412570
(43) Date de publication de la demande: 31.05.2006
(73) Titulaire: STMICROELECTRONICS SA, 92120 Montrouge (FR); COMMISSARIAT A L'ENERGIE ATOMIQUE, 75015 Paris (FR)
(72) Inventeur: Andre, Bernard, FR-38000 Grenoble (FR); Sillon, Nicolas, FR-38600 Fontaine (FR)
(74) Mandataire: Bentz, Jean-Paul

(56) Documents cités:
- WO-A-03/084861
- US-B1- 6 429 506
- US-B1- 6 722 030

## Description

L'invention concerne, de façon générale, les techniques de conditionnement de micro-composants électroniques.

Plus précisément, l'invention concerne un procédé de conditionnement de micro-composants, tels que des micro-systèmes électromécaniques, réalisés en nombre sur une même plaquette de substrat, ce procédé comprenant une opération consistant à enfermer chaque micro-composant dans une cavité entourée par au moins deux parois dont l'une est constituée par le substrat.

En dépit des nombreuses techniques de fabrication développées en micro-électronique, le conditionnement des micro-composants, et en particulier des micro-systèmes électromécaniques, reste une opération relativement longue, complexe et coûteuse (confer, par exemple, la demande de brevet WO03/084861), l'invention ayant précisément pour but de proposer un procédé de conditionnement exempt de ces défauts.

A cette fin, le procédé de l'invention, par ailleurs conforme à la définition générique qu'en donne le préambule ci-dessus, est essentiellement caractérisé en ce qu'il comprend une opération préparatoire consistant à réaliser une plaque de recouvrement dimensionnée pour recouvrir simultanément plusieurs micro-composants ou tous les micro-composants de la plaquette et formée d'un empilement comprenant au moins une matrice réalisée en un matériau mécaniquement et chimiquement stable dans une face inférieure de laquelle sont pratiqués des renfoncements, une couche de matériau polymère déposée sur la face inférieure de la matrice et dont une face inférieure, distante de la matrice, présente des renfoncements reproduisant sensiblement la forme des renfoncements de la matrice, et une couche de métal déposée sur la face inférieure de la couche de matériau polymère et dont une face inférieure présente des renfoncements reproduisant sensiblement ceux de la face inférieure de la couche de matériau polymère, ce procédé comprenant en outre une étape de scellement incluant une opération de recouvrement suivie d'opérations concomitantes de pressage et de chauffage, conduisant à un scellement de la couche de métal sur la face supérieure de la plaquette, la couche de métal formant ainsi une deuxième paroi pour chaque cavité, et une opération de libération, postérieure à l'étape de scellement et consistant à libérer la matrice de la couche de matériau polymère en dissolvant au moins partiellement cette dernière dans un solvant, la matrice étant ainsi réutilisable.

Comme le comprendra aisément l'homme du métier, les adjectifs de localisation tels que "inférieure" et "supérieure" sont à interpréter de façon relative et dans un référentiel spatial librement choisi par rapport au repère terrestre.

Il est avantageux de prévoir que l'opération de recouvrement consiste à recouvrir la plaquette par la plaque de recouvrement, la couche de métal formant ainsi au moins localement une couche intermédiaire en contact à la fois avec la couche de matériau polymère et avec la face supérieure de la plaquette, que l'opération de pressage consiste à appliquer, sur la plaquette et sur la matrice, une pression de contact au moins égale à un bar, que l'opération de scellement consiste à chauffer, jusqu'à l'obtention du scellement, la couche de métal de la couche intermédiaire au moins en une pluralité de zones formant des zones de scellement, chaque cavité étant dotée d'au moins une zone de scellement, et que l'opération de scellement soit mise en oeuvre en irradiant, à travers la matrice et la couche de matériau polymère, la couche de métal par un rayonnement électromagnétique absorbé par cette couche de métal, la matrice et la couche de matériau polymère étant réalisées dans des matériaux respectifs tous deux transparents vis-à-vis de ce rayonnement électromagnétique.

Le rayonnement électromagnétique peut être constitué par un faisceau lumineux dans le domaine de l'infrarouge, par exemple produit par un laser YAG Nd.

Par ailleurs, le rayonnement électromagnétique peut être appliqué séquentiellement ou en parallèle sur toute la plaque de recouvrement.

Il est notamment possible, bien qu'optionnel, de prévoir que le métal soit constitué d'or ou en contienne et que le substrat et / ou la matrice soit constitués de silicium ou en contienne.

De préférence, chaque cavité est intégralement entourée par sa zone de scellement.

Le procédé de conditionnement tel que défini précédemment peut être complété par une opération de découpe, postérieure à l'opération de libération, et consistant à séparer les uns des autres les micro-composants d'une même plaquette, chaque micro-composant restant encapsulé dans sa cavité.

De préférence, le matériau polymère est choisi pour se dégrader lors du chauffage de la couche de métal, ce chauffage provoquant ainsi un décollement de la face inférieure de la couche de matériau polymère par rapport à la couche de métal.

D'autres caractéristiques et avantages de l'invention ressortiront clairement de la description qui en est faite ci-après, à titre indicatif et nullement limitatif, en référence aux dessins annexés, dans lesquels :

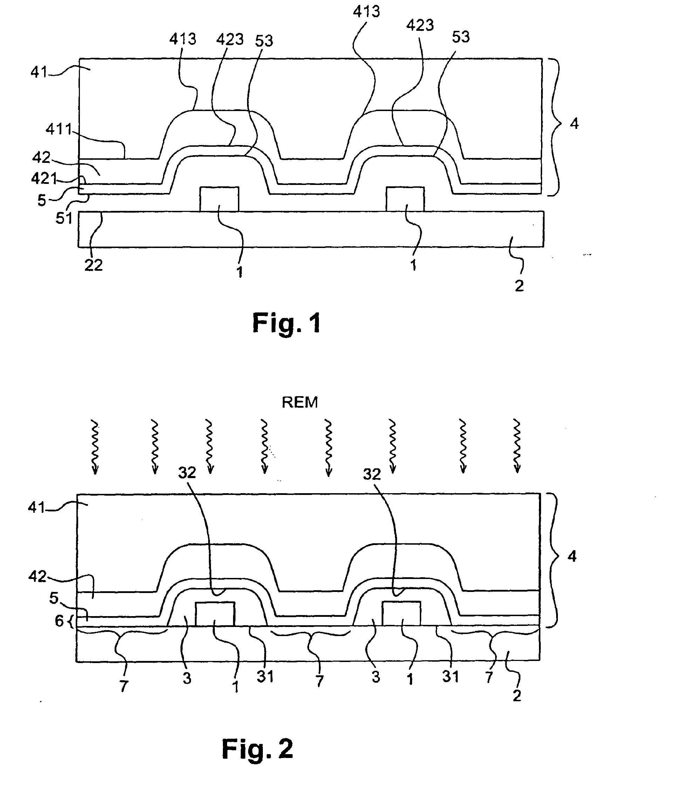

- la figure 1 est une vue en coupe partielle agrandie et schématique d'une plaquette de substrat et d'une plaque de recouvrement, préparées en vue de leur scellement conformément au procédé de l'invention; et
- la figure 2 est une vue en coupe partielle agrandie et schématique d'une plaquette de substrat et d'une plaque de recouvrement, en cours de scellement conformément au procédé de l'invention.

Comme annoncé précédemment, l'invention concerne notamment un procédé pour conditionner des micro-composants 1, en particulier des micro-systèmes électromécaniques, préalablement réalisés en nombre sur une même plaquette ou galette 2 de substrat, par exemple en un matériau semi-conducteur tel que le silicium, ou en matériau composite tel qu'un verre recouvert d'une couche de polysilicium.

La finalité de ce procédé est d'enfermer chaque micro-composant 1 dans une cavité 3 entourée par plusieurs parois telles que 31 et 32, et dont la première paroi 31 est constituée par le substrat 2.

Pour ce faire, le procédé de l'invention comprend tout d'abord une opération préparatoire consistant à réaliser une plaque de recouvrement 4 dimensionnée pour recouvrir simultanément plusieurs micro-composants 1 de la plaquette 2, et très préférablement même tous les micro-composants 1 de cette plaquette.

Cette plaque de recouvrement 4 est formée d'un empilement comprenant une matrice 41, une couche 42 de matériau polymère, et une couche de métal 5, par exemple de l'or.

La matrice 41 est réalisée en un matériau mécaniquement et chimiquement stable, par exemple en silicium, et présente, sur sa face inférieure 411, des renfoncements 413 disposés comme le sont les micro-composants 1 sur la plaquette 2.

Les termes "inférieur" et "supérieur" doivent ici s'entendre pour une certaine orientation arbitraire dans l'espace, correspondant aux dessins.

Par ailleurs, la caractéristique de stabilité mécanique et chimique de la matrice 41 doit être comprise comme étant limitée aux conditions d'utilisation de cette matrice telles que précisées ci-dessous, dont l'homme du métier comprendra notamment que cette matrice 41 doit ne pas être soluble dans un solvant utilisé pour dissoudre la couche 42 de matériau polymère.

Cette couche 42 de matériau polymère est déposée sur la face inférieure 411 de la matrice 41 et présente, sur sa propre face inférieure 421, distante de la matrice 41, des renfoncements 423 reproduisant sensiblement la forme des renfoncements 413 de la matrice 41.

La couche de métal 5 est déposée sur la face inférieure 421 de la couche 42 de matériau polymère et présente elle-même, sur sa face inférieure 51, des renfoncements 53 reproduisant sensiblement la forme des renfoncements 423 de la face inférieure 421 de la couche 42 de matériau polymère.

Le procédé de l'invention comprend en outre une étape de scellement incluant une opération de recouvrement suivie d'opérations concomitantes de pressage et de chauffage, conduisant à un scellement de la couche de métal 5 sur la face supérieure 22 de la plaquette 2.

L'opération de recouvrement consiste à recouvrir la plaquette 2 par la plaque de recouvrement 4, la couche de métal 5 formant ainsi au moins localement une couche intermédiaire 6 en contact à la fois avec la couche 42 de matériau polymère et avec la face supérieure 22 de la plaquette 2, et cette couche de métal 5 formant par ailleurs une deuxième paroi 32 pour chaque cavité 3.

L'opération de pressage consiste à appliquer, sur la plaquette 2 et sur la matrice 41, une pression de contact au moins égale à un bar, et typiquement comprise entre 1 et 5 bars.

L'opération de scellement consiste à chauffer, jusqu'à l'obtention du scellement, la couche 5 de métal de la couche intermédiaire 6 en une pluralité de zones destinées à former des zones de scellement 7 et distribuées de manière telle que chaque cavité 3 soit dotée d'au moins une telle zone de scellement 7.

La température de chauffage atteint typiquement 400 °C localement, c'est-à-dire une température supérieure à celle de l'eutectique or-silicium dans le cas où la couche de métal 5 est constituée d'or et où le substrat 2 est constitué de silicium.

Des températures différentes, et notamment supérieures, peuvent cependant être prévues dans les cas d'utilisation d'autres métaux ou alliages ou d'autres matériaux pour le substrat.

Cette opération de scellement est de préférence mise en oeuvre en irradiant la couche de métal 5, à travers la matrice 41 et la couche 42 de matériau polymère, par un rayonnement électromagnétique REM absorbé par cette couche de métal.

Dans ce cas, la matrice 41 et la couche 42 de matériau polymère doivent cependant être réalisées dans des matériaux respectifs tous deux transparents vis-à-vis de ce rayonnement électromagnétique REM.

Le rayonnement électromagnétique REM est avantageusement constitué par un faisceau lumineux dans le domaine de l'infrarouge, par exemple un faisceau de 1064 nm de longueur d'onde produit par un laser YAG Nd pulsé ou continu.

Le rayonnement électromagnétique REM peut être appliqué sous la forme d'un faisceau sélectivement dirigé, par mouvement relatif de ce faisceau et de la plaquette 2, sur les zones à chauffer destinées à devenir des zones de scellement 7.

Il peut néanmoins aussi être appliqué séquentiellement ou en parallèle sur toute la surface de la plaque de recouvrement 4, les micro-composants 1 étant protégés d'une irradiation directe par la couche de métal 5 qui les surplombe.

Le matériau polymère de la couche 42 peut avantageusement être choisi parmi les polymères connus pour se dégrader par élévation de leur température.

Ainsi, la dégradation de cette couche 42 résultant du chauffage de la couche de métal 5 provoque spontanément le décollement de la face inférieure 421 de cette couche 42 de matériau polymère par rapport à la couche de métal 5.

Postérieurement à l'étape de scellement, le procédé de l'invention comprend une opération de libération qui consiste à libérer la matrice 41 de la couche 42 de matériau polymère en dissolvant au moins partiellement cette dernière dans un solvant.

En raison de sa stabilité mécanique et chimique, la matrice 41 résiste sans dommage à ce traitement, et peut donc être réutilisée.

Pour assurer une protection optimale de chaque micro-composant 1, il est utile de prévoir que la zone de scellement 7 associée à chaque cavité 3 entoure intégralement cette dernière et la rende ainsi étanche.

Postérieurement à l'opération de libération, le procédé de l'invention comprend une opération de découpe qui consiste à séparer les uns des autres les micro-composants 1 d'une même plaquette 2 en découpant la plaquette 2 et la couche métallique 5 tout autour de chaque cavité 3, chaque micro-composant 1 restant ainsi encapsulé dans sa cavité 3.

L'invention concerne également bien sûr tout ensemble de micro-composants, tels que des micro-systèmes électromécaniques 1, réalisé par la mise en oeuvre d'un procédé tel que précédemment décrit.

## Revendications

1. Procédé de conditionnement de micro-composants (1), tels que des micro-systèmes électromécaniques, réalisés en nombre sur une même plaquette (2) de substrat, ce procédé comprenant une opération consistant à enfermer chaque micro-composant (1) dans une cavité (3) entourée par au moins deux parois (31, 32) dont l'une (31) est constituée par le substrat (2), **caractérisé en ce qu**'il comprend une opération préparatoire consistant à réaliser une plaque de recouvrement (4) dimensionnée pour recouvrir simultanément plusieurs micro-composants (1) ou tous les micro-composants (1) de la plaquette (2) et formée d'un empilement comprenant au moins une matrice (41) réalisée en un matériau mécaniquement et chimiquement stable dans une face inférieure (411) de laquelle sont pratiqués des renfoncements (413), une couche (42) de matériau polymère déposée sur la face inférieure (411) de la matrice (41) et dont une face inférieure (421), distante de la matrice (41), présente des renfoncements (423) reproduisant sensiblement la forme des renfoncements (413) de la matrice (41), et une couche de métal (5) déposée sur la face inférieure (421) de la couche (42) de matériau polymère et dont une face inférieure (51) présente des renfoncements (53) reproduisant sensiblement ceux (423) de la face inférieure (421) de la couche (42) de matériau polymère, ce procédé comprenant en outre une étape de scellement incluant une opération de recouvrement suivie d'opérations concomitantes de pressage et de chauffage, conduisant à un scellement de la couche de métal (5) sur la face supérieure (22) de la plaquette (2), la couche de métal (5) formant ainsi une deuxième paroi (32) pour chaque cavité (3), et une opération de libération, postérieure à l'étape de scellement et consistant à libérer la matrice (41) de la couche (42) de matériau polymère en dissolvant au moins partiellement cette dernière dans un solvant, la matrice (41) étant ainsi réutilisable.

2. Procédé de conditionnement suivant la revendication 1, **caractérisé en ce que** l'opération de recouvrement consiste à recouvrir la plaquette (2) par la plaque de recouvrement (4), la couche (5) de métal formant ainsi au moins localement une couche intermédiaire (6) en contact à la fois avec la couche (42) de matériau polymère et avec la face supérieure (22) de la plaquette (2), **en ce que** l'opération de pressage consiste à appliquer, sur la plaquette (2) et sur la matrice (41), une pression de contact au moins égale à un bar, **en ce que** l'opération de scellement consiste à chauffer, jusqu'à l'obtention du scellement, la couche (5) de métal de la couche intermédiaire (6) au moins en une pluralité de zones formant des zones de scellement (7), chaque cavité (3) étant dotée d'au moins une zone de scellement (7), et **en ce que** l'opération de scellement est mise en oeuvre en irradiant, à travers la matrice (41) et la couche (42) de matériau polymère, la couche de métal (5) par un rayonnement électromagnétique (REM) absorbé par cette couche de métal, la matrice (41) et la couche (42) de matériau polymère étant réalisées dans des matériaux respectifs tous deux transparents vis-à-vis de ce rayonnement électromagnétique (REM).

3. Procédé de conditionnement suivant la revendication 2, **caractérisé en ce que** le rayonnement électromagnétique (REM) est constitué par un faisceau lumineux dans le domaine de l'infrarouge, par exemple produit par un laser YAG Nd.

4. Procédé de conditionnement suivant la revendication 2 ou 3, **caractérisé en ce que** le rayonnement électromagnétique (REM) est appliqué séquentiellement ou en parallèle sur toute la plaque de recouvrement (4).

5. Procédé de conditionnement suivant l'une quelconque des revendications précédentes, **caractérisé en ce que** le métal (5) est constitué d'or ou en contient.

6. Procédé de conditionnement suivant l'une quelconque des revendications précédentes, **caractérisé en ce que** le substrat (2) est constitué de silicium ou en contient.

7. Procédé de conditionnement suivant l'une quelconque des revendications précédentes, **caractérisé en ce que** la matrice (41) est constituée de silicium ou en contient.

8. Procédé de conditionnement suivant l'une quelconque des revendications précédentes combinée à la revendication 2, **caractérisé en ce que** chaque cavité (3) est intégralement entourée par sa zone de scellement (7).

9. Procédé de conditionnement suivant l'une quelconque des revendications précédentes, **caractérisé en ce qu**'il comprend une opération de découpe, postérieure à l'opération de libération, et consistant à séparer les uns des autres les micro-composants (1) d'une même plaquette (2), chaque micro-composant (1) restant encapsulé dans sa cavité (3).

10. Procédé de conditionnement suivant l'une quelconque des revendications précédentes, **caractérisé en ce que** le matériau polymère (42) est choisi pour se dégrader lors du chauffage de la couche de métal (5), ce chauffage provoquant ainsi un décollement de la face inférieure (421) de la couche (42) de matériau polymère par rapport à la couche de métal (5).

## Claims

1. Process for packaging a number of micro-components (1) such as electromechanical micro-systems on the same substrate wafer (2), this process including an operation consisting of enclosing each micro-component (1) in a cavity (3) surrounded by at least two walls (31, 32), one of which (31) is formed by the substrate (2), **characterised in that** it comprises a preparatory operation consisting of making a covering plate (4) sized to simultaneously cover several micro-components (1) or all micro-components (1) in the wafer (2) and formed from a stack comprising at least one matrix (41) made of a mechanically and chemically stable material in a lower face (411) of which depressions (413) are formed, a layer (42) of polymer material deposited on the lower face (411) of the matrix (41) and of which a lower face (421) remote from the matrix (41) is provided with depressions (423) approximately reproducing the shape of the depressions (413) in the matrix (41), and a metal layer (5) deposited on the lower face (421) of the layer (42) of polymer material and the lower face (51) of which is provided with depressions (53) approximately reproducing the depressions (423) on the lower face (421) of the layer (42) of polymer material, this process further comprising a sealing step including a covering operation followed by concomitant pressing and heating operations, leading to the metal layer (5) being sealed onto the upper face (22) of the wafer (2), the metal layer (5) thus forming a second wall (32) for each cavity (3), and a release operation subsequent to the sealing step, consisting of releasing the matrix (41) from the layer (42) of polymer material, by at least partially dissolving this layer in a solvent, the matrix (41) thus being re-useable.

2. Packaging process according to claim 1, **characterised in that** the covering operation consists of covering the wafer (2) by the covering plate (4), the metal layer (5) thus at least locally forming an intermediate layer (6) in contact with the layer (42) of polymer material and also with the upper face (22) of the wafer (2), **in that** the pressing operation consists of applying contact pressure on the wafer (2) and on the matrix (41) equal to at least one bar, **in that** the sealing operation consists of heating the metal layer (5) in the intermediate layer (6) at at least a plurality of areas forming sealing areas (7) until sealing is achieved, each cavity (3) having at least one sealing area (7), and **in that** the sealing operation is carried out by irradiating the metal layer (5) through the matrix (41) and the layer (42) of polymer material, by an electromagnetic radiation (REM) absorbed by this metal layer, both the matrix (41) and the layer (42) of polymer material being made from respective materials that are transparent to this electromagnetic radiation (REM).

3. Packaging process according to claim 2, **characterised in that** the electromagnetic radiation (REM) is composed of a light beam in the infrared range, for example produced by an Nd YAG laser.

4. Packaging process according to claim 2 or 3, **characterised in that** the electromagnetic radiation (REM) is applied sequentially or in parallel over the entire covering plate (4).

5. Packaging process according to any one of the previous claims, **characterised in that** the metal (5) is composed of gold or contains gold.

6. Packaging process according to any one of the previous claims, **characterised in that** the substrate (2) is composed of silicon or contains silicon.

7. Packaging process according to any one of the previous claims, **characterised in that** the matrix (41) is composed of silicon or contains silicon.

8. Packaging process according to any one of the previous claims combined with claim 2, **characterised in that** each cavity (3) is integrally surrounded by its sealing area (7).

9. Packaging process according to any one of the previous claims, **characterised in that** the process comprises a cutting operation after the release operation, consisting of separating the micro-components (1) on the same wafer (2) from each other, each micro-component (1) remaining encapsulated in its cavity (3).

10. Packaging process according to any one of the previous claims, **characterised in that** the polymer material (42) is chosen to degrade during heating of the metal layer (5), this heating thus causing the lower face (421) of the polymer material layer (42) to come unstuck from the metal layer (5).

## Patentansprüche

1. Konditionierungsverfahren von Mikrobauelementen (1), wie elektromechanische Mikrosysteme, die auf ein und demselben Substratwafer (2) zahlreich verwirklicht sind, wobei das Verfahren einen Vorgang umfasst, der darin besteht, jedes Mikrobauelement (1) in ein Gehäuse (3) einzuschließen, das durch wenigstens zwei Wände (31, 32) umgeben ist, von denen eine (31) durch das Substrat (2) gebildet wird, **dadurch gekennzeichnet, dass** dieses einen Präparationsvorgang umfasst, der darin besteht, eine Deckplatte (4) herzustellen, die so bemessen ist, dass gleichzeitig mehrere Mikrobauelemente (1) oder alle Mikrobauelemente (1) des Wafer (2) abgedeckt sind, und die aus einem Stapel gebildet wird, der aufweist wenigstens eine Matrix (41) aus einem mechanisch und chemisch stabilen Material in einer Unterseite (411), aus welchem Verstärkungen (413) hergestellt werden, eine Schicht (42) aus Polymermaterial, die auf der Unterseite (411) der Matrix (41) angeordnet ist und deren von der Matrix (41) entfernt liegende Unterseite (421) Verstärkungen (423) aufweist, die im Wesentlichen die Form der Verstärkungen (413) der Matrix (41) wiedergeben, und eine Metallschicht (5), die auf der Unterseite (421) der Schicht (42) aus Polymermaterial angeordnet ist und deren eine Unterseite (51) Verstärkungen (53) aufweist, die im Wesentlichen diejenigen (423) der Unterseite (421) der Schicht (42) aus Polymermaterial reproduzieren, wobei das Verfahren ferner umfasst einen Versiegelungsschritt, der einen Abdeckvorgang beinhaltet, dem gleichzeitige Press- und Erhitzungsvorgänge folgen, was zu einer Versiegelung der Metallschicht (5) auf der Unterseite (22) des Wafer (2) führt, wobei die Metallschicht (5) somit eine zweite Wand (32) für jedes Gehäuses (3) bildet, und einen Freigabevorgang nach dem Versiegelungsschritt, der darin besteht, die Matrix (41) der Schicht (42) aus Polymermaterial unter wenigstens teilweiser Auflösung dieser letzteren in einem Lösungsmittel freizulegen, wobei die Matrix (41) **dadurch** wieder verwendbar wird.

2. Konditionierungsverfahren nach Anspruch 1, **dadurch gekennzeichnet dass** der Abdeckvorgang darin besteht, den Wafer (2) mit der Deckplatte (4) abzudecken, wobei die Metallschicht (5) auf diese Weise wenigstens örtlich eine Zwischenschicht (6) bildete, die sowohl mit der Schicht (42) aus Polymermaterial als auch mit der Oberseite (22) des Wafer (2) in Kontakt steht, dass der Pressvorgang darin besteht, auf den Wafer (2) und auf die Matrix (41) einen Druckkontakt wenigstens von einem bar auszuüben, dass der Versiegehungsvorgang darin besteht, die Schicht (5) aus Metall der Zwischenschicht (6) bis zum Erhalt der Versiegelung wenigstens in einer Mehrzahl von Zonen zu erhitzen, die Versiegelungszonen (7) bilden, wobei jedes Gehäuse (3) mit wenigstens einer Versiegehungszone (7) versehen ist, dass der Versiegelungsvorgang durch Bestrahlen der Metallschicht (5) durch die Matrix (41) und die Schicht (42) aus Polymermaterial hindurch mit einer elektromagnetischen Strahlung (REM) durchgerührt wird, die durch diese Metallschicht absorbiert wird, wobei die Matrix (41) und die Schicht (42) aus Polymermaterial in den jeweiligen Materialien beide gegenüber elektromagnetischer Strahlung (REM) durchlässig ausgebildet sind.

3. Konditionierungsverfahren nach Anspruch 2, **dadurch gekennzeichnet, dass** die elektromagnetische Strahlung (REM) durch ein Lichtbündel im Infrarotbereich gebildet wird, erzeugt zum Beispiel durch einen YAG Nd Laser.

4. Konditionierungsverfahren nach Anspruch 2 oder 3, **dadurch gekennzeichnet, dass** die elektromagnetische Strahlung (REM) sequentiell oder parallel auf die ganze Deckplatte (4) aufgebracht wird.

5. Konditionierungsverfahren nach einem der vorhergehenden Ansprüche, **dadurch gekennzeichnet, dass** das Metall (5) aus Gold besteht oder dieses enthält.

6. Konditionierungsverfahren nach einem der vorhergehenden Ansprüche, **dadurch gekennzeichnet, dass** das Substrat (2) aus Silizium besteht oder dieses enthält.

7. Konditionierungsverfahren nach einem der vorhergehenden Ansprüche, **dadurch gekennzeichnet, dass** die Matrix (41) aus Silizium besteht oder dieses enthält.

8. Konditionierungsverfahren nach einem der vorhergehenden Ansprüche, kombiniert mit Anspruch 2, **dadurch gekennzeichnet, dass** jedes Gehäuse (3) durch seine Versiegelungszone (7) einstückig umgeben wird.

9. Konditionierungsverfahren nach einem der vorhergehenden Ansprüche, **dadurch gekennzeichnet, dass** dieses einen Zuschneidevorgang nach dem Freigabevorgang umfasst, der darin besteht, die Mikrobauelemente (1) ein und derselben Wafer (2) voneinander zu trennen, wobei jedes Mikrobauelement (1) in seinem Gehäuse (3) eingekapselt bleibt.

10. Konditionierungsverfahren nach einem der vorhergehenden Ansprüche, **dadurch gekennzeichnet, dass** das Polymermaterial (42) so gewählt wird, dass sich dieses bei der Erhitzung der Metallschicht (5) zersetzt, wobei die Erhitzung auf diese Weise eine Ablösung der Unterseite (421) der Schicht (42) aus Polymermaterial in Bezug zur Metallschicht (5) herbeiführt.
